# EUROPEAN PATENT APPLICATION

(11) **EP 4 227 738 A1**
(43) Date of publication of application: **16.08.2023**
(21) Application number: 22156582.3
(22) Date of filing: 14.02.2022
(51) Int. Cl.: G03F 7/20, H01L 21/67, H01L 21/683

(54) **CLAMP**

(71) Applicant: ASML Netherlands B.V., 5500 AH Veldhoven (NL)
(72) Inventor: MEISSNER, Torsten, D-12347 Berlin (DE); HUANG, Zhuangxiong, 5500 AH Veldhoven (NL); TRALLI, Aldo, 5500 AH Veldhoven (NL)
(74) Representative: ASML Netherlands B.V.

(57) **Abstract**

A support for supporting a partial or complete clamp during manufacture of the clamp, wherein the support comprises a raised flexible element located on a top surface, the flexible element being configured to deform as a result of a gas pressure differential acting on the flexible element to create gas flow restriction between a space between the clamp and the support, and a space outside the clamp.

## Description

### FIELD

The present disclosure relates to a support for supporting a partial or complete clamp during manufacturing of the clamp. The present disclosure also related to a method of vacuum clamping a partial or complete clamp as well as the use of such a support or method in a lithographic apparatus or process. The present disclosure has particular, but not exclusive, application to wafer clamps used in lithographic apparatuses and methods.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate, which may also be referred to as a wafer, is supported within the lithographic apparatus by a wafer table.

Certain lithographic apparatuses which use EUV radiation create the radiation beam by illuminating droplets of a target material with a laser. The EUV Source creating such radiation is sometimes referred to as Laser Produced Plasma source. The laser converts the target material into a plasma, which subsequently releases EUV radiation, which can be collected and formed into a radiation beam.

Due to the high precision required in lithographic apparatuses and methods to form integrated circuits, it is necessary to clamp wafers in place for imaging. The clamps used to clamp wafers in place consequently also require highly accurate manufacturing. Vacuum clamps are one type of clamp which are used for mounting components thereon. For example, US2018/0108559 describes method and systems for chucking a warped wafer. This includes providing three or more collapsible bellows that move above the chuck and into direct contact with a warped substrate. The bellows seal and vacuum clamp onto the backside surface of the substrate and collapse and pull the wafer downwards where it touches extensible sealing elements which collapse into a flat chucking surface of the chuck body. This involves direct impingement of the bellows seal on the substrate, which can cause distortion of the substrate. US2004/0166789 describes a method of sealing a wafer backside for full-face processing in which gas emitted through holes onto a peripheral back edge of the wafer assist in preventing processing liquids and contaminants from reaching the inner region of a base and a backside inner region of the wafer, or providing a plurality of concentric sealing members, the outer seal being independently movable to allow cleaning of a peripheral backside of the wafer whilst the wafer is still attached to the wafer carrier. This requires that the wafer and the seal are in contact to form a liquid-tight seal. Again, this requires direct contact between the seal and the wafer. Similarly, US2016/0276196 describes a ceramic electrostatic chuck bonded with high temperature polymer bond to a metal base which includes an o-ring which seals against a chuck and a cooling base.

The present invention has been provided with a view to addressing at least some of the drawbacks of existing systems.

### SUMMARY

When manufacturing a clamp, it is provided on top of a chuck and the gas between the clamp body and the chuck is removed in order to create a vacuum, which holds the clamp body in place on the chuck. The pressure differential is typically around 0.5 bar. In this way, the clamp body is supported firmly for processing, such as flatness measurement, polishing of burls or other processing steps. One issue faced is that the clamp can be shaped such that it is very leaky to gas and so it is difficult or impossible to obtain and maintain the required vacuum conditions with existing equipment. This is particularly the case where the clamp is partially finished as there is very little flow restriction between the periphery of the clamp body and the chuck. In addition, clamps are designed such that in use there is an outflow of gas to provide a shield against contaminants.

According to a first aspect of the present disclosure, there is provided a support for supporting a partial or complete clamp during manufacture of the clamp, wherein the support comprises a raised flexible element located on a top surface, the flexible element being configured to deform as a result of a gas pressure differential acting on the flexible element to create gas flow restriction between a space between the clamp and the support, and a space outside the clamp.

In this way, the present disclosure provides a support which is able to create a flow restriction between a space between the clamp and the support, and a space outside the clamp as a result of deformation of a raised flexible element. In existing systems, a seal is provided which functions by two surfaces engaging with one another, whereas the present disclosure does not required such physical interaction, but rather a pressure differential giving rise to deformation of a flexible element. This provides an automatic flexible seal that can accommodate different gaps. At different stages of manufacture, the size of the gap which is to be partially sealed can vary. As such, with a conventional o-ring, the o-ring would need to be compressed more at some stages than at others. This would result in different amounts of force being applied, which can lead to unwanted distortions or damage. Due to the sensitivity of the clamp and the potential for damage, it is undesirable for anything to touch the clamp unless necessary. The support according to the present disclosure allows the flexible element to handle a larger degree of dimensional tolerance and can safely close the gap to a smaller tolerance than possible using a rigid or fixed seal. The support according to the present disclosure can also reduce the time taken to achieve the desired vacuum, thereby improving cycle time.

The flexible element may be inflatable. As such, the shape of the flexible element may be altered by an internal pressure being higher than an external pressure. The pressure differential acting on the flexible element causes the flexible element to inflate. In this way, the extent of the inflation can be controlled by adjusting the pressure differential, with a higher differential leading to greater deformation.

The flexible element may be configured to be spaced apart from the clamp when at a maximum deformation. As such, the flexible element does not come into physical contact with the clamp, which could potentially cause damage to the clamp.

The flexible element may include a connector for connection to a pressurization pump. One way in which the deformation of the flexible element may be controlled is by the alteration of pressure within the flexible element. Again, a higher internal pressure will result in greater deformation and therefore it is possible to accommodate different sized gaps. Alternatively, the flexible element may be a sealed tube which has a fixed pressure contained therein.

The flexible element may include at least two stacks bridged by a flexible membrane. The flexible element is raised such that the degree to which deformation is required is lessened. If the flexible element were flush with the top surface, it would require a greater degree of deformation.

The stacks may be formed from stacked foil layers. The foil layers may be made of PVC foil. The portion of the flexible element bridging the stacks may be formed from a foil layer. In this way, the stacked foil layers bring the bridging portion closer to the clamp and thereby reduce the amount by which the bridging portion needs to flex to create a gas flow restriction.

In another embodiment, the flexible element may include a curved rim having a convex face and a concave face. The curved rim may be configured such that the concave face is inwardly facing. In such an embodiment, the flexible element has a c-shaped cross sectional shape. In this way, the flexible element deforms due to the pressure differential between the concave and the convex faces.

The flexible element may be configured to deform by up to around 0.5 mm, up to around 0.4 mm, up to around 0.3 mm, up to around 0.2 mm, or up to around 0.1 mm

The support may include one or more vacuum ports for providing a vacuum.

According to a second aspect of the present disclosure, there is provided a method of vacuum clamping a partial or complete clamp, the method including the steps of: a) providing a support comprising a raised flexible element located on a top surface, the flexible element being configured to deform as a result of a gas pressure differential acting on the flexible element to create gas flow restriction between a space between the clamp and the support, and a space outside the clamp; b) providing a partial or complete clamp on the support; c) operating a vacuum source to generate a pressure differential between the space between the clamp and the support, and the space outside the clamp, to cause the raised flexible element to deform and create a gas flow restriction between the space between the clamp and the support, and the space outside the clamp.

As described in respect of the first aspect of the present disclosure, the present disclosure provides a method of providing a seal for a clamp which is able to adapt to differently sized gaps and which does not require compression of the sealing element against the clamp. The flexible sealing element may be the sealing element described in accordance with the first aspect of the present disclosure.

The method may include operating a vacuum source to generate a pressure differential of at least 0.1 barg, 0.2 barg, 0.3 barg, 0.4 barg, 0.5 barg, 0.6 barg, 0.7 barg, 0.8 barg, or 0.9 barg, or more. The magnitude of the pressure differential acting across the flexible element can be used to control the magnitude of the deformation thereof.

According to a third aspect of the present disclosure, there is provided the use of a support according to the first aspect of the present disclosure or a method according to the second aspect of the present disclosure in a lithographic apparatus or process.

In any aspect described herein, the clamp may be a wafer clamp. The wafer clamp may include wafer burls.

The features of any aspect of the present invention may be combined except where the features are mutually incompatible and all such combinations are explicitly considered and disclosed.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 is a schematic depiction of a cross section of a clamp clamped on a support;
- Figure 3 is a schematic depiction of a cross section of a support according to an embodiment of the present disclosure;
- Figure 4 is a schematic depiction of a cross section of a support according to an embodiment of the present disclosure; and
- Figure 5 is a sectional view of a flexible member according to an embodiment of the present disclosure.

### DETAILED DESCRIPTION

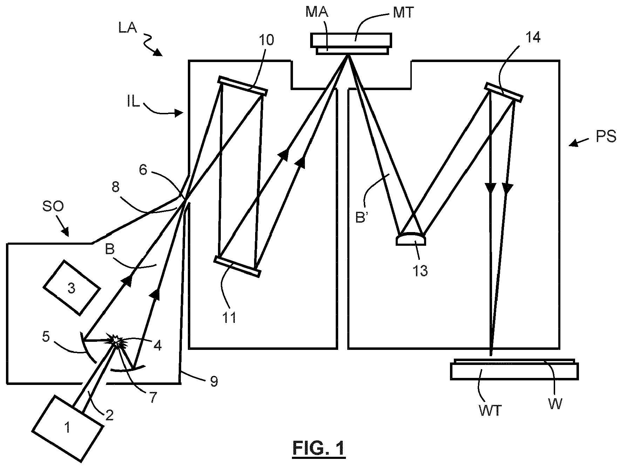

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. The substrate may be a wafer. The wafer may be held in position by a burled clamp. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma. The fuel emitter 3 may be part of a droplet generator assembly (not shown). The droplet generator assembly may be supplied with liquid tin via the connection assembly according to the present invention.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

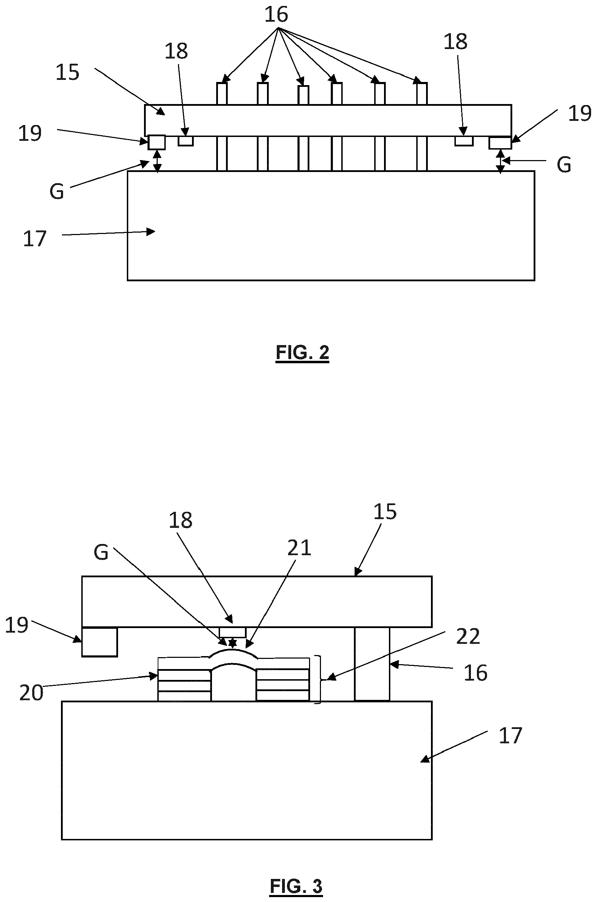

Figure 2 is a schematic depiction of a clamp 15 comprising a plurality of burls 16. The clamp 15 is supported on a support 17 in the form of a chuck. The burls 16 on the bottom face of the clamp 15 are supported on the surface of the support 17. The clamp 15 also includes a glue pad ring 18 on its bottom surface as well as a peripheral core edge 19. There is a gap G between the surface of the support 17 and the peripheral core edge 19 as well as between the surface of the support 17 and the glue pad ring 18. Vacuum applied to the clamp 15 is therefore able to be lost via transfer of gas from the outside through gap G. It is desirable for the seal to not touch the clamp as this may cause the clamp to shift or change orientation.

Figure 3 depicts a section of an embodiment of a support 17 in accordance with the present disclosure. The flexible seal 22 includes two stacks 20 made up of layers of foil. It will be appreciated that the stacks 20 can be made of other materials and do not necessarily have to be formed of layers. For example, the stacks may be unitary with the material comprising the support 17 and may extend from a surface thereof. The flexible seal 22 includes a bridging portion 21 which spans the two stacks 20. As depicted, the bridging portion 21 is deformed such that the gap G between theglue pad ring 18 and the bridging portion 21 is reduced in size relative to when the bridging portion 21 is substantially flat. Even when the bridging portion is substantially flat, such as when a vacuum has just been applied, since it is raised from the surface of the support 17, it is able to function to restrict gas flow. In contrast, should the flexible bridging portion be flush with the surface of the support, it would be ineffective or uch less effective in providing a flow restriction when a vacuum is applied since in its resting state it offers little to no resistance, so it would not be practical to generate a sufficient pressure differential to cause it to deform and close the gap. It will be appreciated that whilst Figure 3 depicts a single flexible seal, there may be more than one provided. For example, another flexible seal could be provided opposite the peripheral core edge 19 in addition to or instead of opposite the glue ring pad 18 as shown in Figure 3.

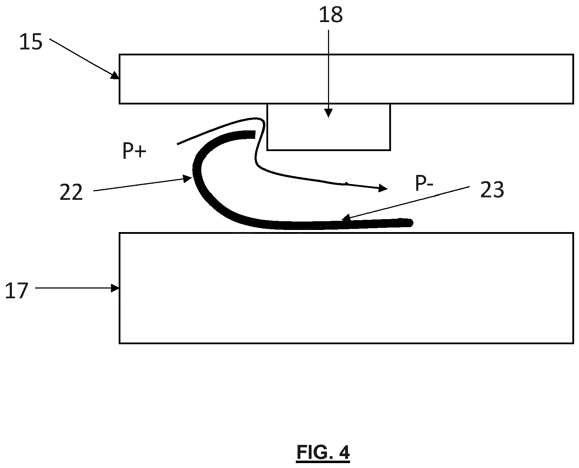

Figure 4 depicts an alternative embodiment of the flexible seal according to the present disclosure. The flexible seal 22 is generally c-shaped in cross-section and has a concave face and a convex face, which the flexible seal 22 being arranged such that the concave face is facing inwardly. The flexible seal 22 may include an apron 23 which is affixed to the support 17 by any suitable means. When there is a pressure differential across the flexible seal 22, the pressure acting on the convex face will tend to deform the seal 22 towards the glue pad ring 18 and thereby reduce the gap through which vacuum can be lost. As shown by the arrow, gas will tend to flow from an area of high pressure P+ to an area of lower pressure P- and the deformation of the flexible seal 22 serves to provide a restriction to this flow.

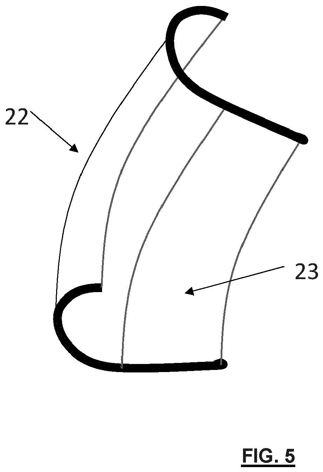

Figure 5 depicts a section of the flexible seal 22 shown in Figure 4. It will be appreciated that this only shows a section of the seal.

The present disclosure provides means by which a leakage path for a vacuum can be reduced to allow effective clamping of a clamp whilst avoiding the need to have the seal come into direct physical contact with the clamp. This avoids any possible damage, distortion or misalignment of the clamp. This also allows a greater range of gaps to be accommodated, which would not be possible with previous systems. In addition, having a raised flexible seal serves to provide an initial flow restriction to allow sufficient pressure differential to be provided in order to allow deformation of the flexible seal to provide additional flow restriction.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A support for supporting a partial or complete clamp during manufacture of the clamp, wherein the support comprises a raised flexible element located on a top surface, the flexible element being configured to deform as a result of a gas pressure differential acting on the flexible element to create gas flow restriction between a space between the clamp and the support, and a space outside the clamp.

2. The support according to claim 1, wherein the flexible element is inflatable.

3. The support according to claim 1 or claim 2, wherein the flexible element is configured to be spaced apart from the clamp when at a maximum deformation.

4. The support according to any preceding claim, wherein the flexible element includes a connector for connection to a pressurization pump.

5. The support according to any preceding claim, wherein the flexible element includes at least two stacks bridged by a flexible membrane.

6. The support according to claim 5, wherein the at least two stacks are formed from stacked foil layers and/or wherein the flexible membrane bridging the at least two stacks is formed from a foil layer.

7. The support according to claim 1, wherein the flexible element includes curved rim having a convex face and a concave face.

8. The support according to claim 7, wherein the curved rim is configured such that the concave face is inwardly facing.

9. The support according to any preceding claim, wherein the flexible element is configured to deform by up to around 0.5 mm, up to around 0.4 mm, up to around 0.3 mm, up to around 0.2 mm, or up to around 0.1 mm

10. The support according to any preceding claim, wherein the support includes one or more vacuum ports for providing a vacuum.

11. A method of vacuum clamping a partial or complete clamp, the method including the steps of:
a) providing a support comprising a raised flexible element located on a top surface, the flexible element being configured to deform as a result of a gas pressure differential across the flexible element to create gas flow restriction between a space between the clamp and the support, and a space outside the clamp;
b) providing a partial or complete clamp on the support;
c) operating a vacuum source to generate a pressure differential between the space between the clamp and the support, and the space outside the clamp, to cause the raised flexible element to deform and create a gas flow restriction between the space between the clamp and the support, and the space outside the clamp.

12. The method of Claim 11, wherein the method includes operating a vacuum source to generate a pressure differential of at least 0.1 barg, 0.2 barg, 0.3 barg, 0.4 barg, 0.5 barg, 0.6 barg, 0.7 barg, 0.8 barg, or 0.9 barg, or more.

13. Use of a support according to any of Claims 1 to 10 or a method according to any of Claims 11 or 12 in a lithographic apparatus or process.
